# EUROPEAN PATENT APPLICATION

(11) **EP 2 589 636 A1**
(43) Date of publication of application: **08.05.2013**
(21) Application number: 11800825.9
(22) Date of filing: 28.06.2011
(51) Int. Cl.: C09K 3/00, C08F 290/06, C09D 7/12, C09D 201/00, G03F 7/004

(54) **FLUORINE-BASED SURFACTANT, AND COATING COMPOSITION AND RESIST COMPOSITION EACH USING SAME**

(30) Priority: 02.07.2010 JP 2010151983
(71) Applicant: DIC Corporation, Tokyo 174-8520 (JP)
(72) Inventor: SASAMOTO Shin, Ichihara-shi Chiba 290-8585 (JP); SUZUKI Hideya, Ichihara-shi Chiba 290-8585 (JP)
(74) Representative: Albrecht, Thomas
(86) International application number: PCT/JP2011/064755
(87) International publication number: WO 2012/002361

(57) **Abstract**

Provided is a fluorine-based surfactant including a copolymer synthesized by copolymerizing, as essential monomers, a polymerizable monomer (A) having a poly(perfluoroalkylene ether) chain and polymerizable unsaturated groups at both ends of the chain and a polymerizable monomer (B) having an oxyalkylene group and a polymerizable unsaturated group. The fluorine-based surfactant cannot structurally generate PFOS or PFOA, which tend to accumulate in the environment and living bodies; even when the fluorine-based surfactant has lower fluorine content than surfactants having a fluoroalkyl group having 8 or more carbon atoms, the fluorine-based surfactant has a higher capability of decreasing surface tension than the surfactants. Accordingly, the fluorine-based surfactant can be suitably used as a leveling agent for a coating composition, a resist composition, or the like.

## Description

### Technical Field

The present invention relates to a fluorine-based surfactant that is usable as a leveling agent for various coating materials in various paint fields requiring surface smoothness or in coating fields requiring high-precision coating or for resist materials and that causes less accumulation in the environment and living bodies; and a coating composition and a resist composition that include the surfactant.

### Background Art

In various coating fields, for the purpose of enhancing uniformity and smoothness of the resultant coating films, various surfactants referred to as leveling agents such as hydrocarbon-based agents, silicone-based agents, and fluorine-based agents have been used. In particular, since fluorine-based agents have a high capability of decreasing surface tension and cause less pollution after being applied, they are being widely used.

Regarding such a fluorine-based surfactant, a method of using a polymer including a polymerization unit including an alkyl group in which at least one hydrogen atom is substituted with a fluorine atom and the number of carbon atoms is 20 or less has been proposed (for example, refer to Patent Literature 1). In particular, it is stated that surfactants using a perfluoroalkyl group having 8 or more carbon atoms have good properties as leveling agents due to their capability of decreasing surface tension. However, the properties are difficult to retain in surfactants having a perfluoroalkyl group having 6 or less carbon atoms. As the number of the carbon atoms decreases, the capability of decreasing surface tension is further degraded, which is problematic.

However, in recent years, it has been revealed that decomposition of compounds having a perfluoroalkyl group having 8 carbon atoms can result in generation of perfluorooctanesulfonic acid (hereafter, abbreviated as "PFOS") or perfluorooctanoic acid (hereafter, abbreviated as "PFOA") both of which tend to accumulate in the environment and living bodies. In addition, it has also been revealed that compounds having a perfluoroalkyl group having more than 8 carbon atoms can generate compounds that have a stronger tendency to accumulate in the environment and living bodies. Accordingly, there has been a market demand for a material having a fluoroalkyl group in which the number of carbon atoms is 6 or less so that PFOS and PFOA, which tend to accumulate in the environment and living bodies, cannot be structurally generated, and the chain length is as short as possible, for example, a fluoroalkyl group having 4 or less carbon atoms; or a material having a structure other than fluoroalkyl groups. However, as described above, as the chain length shortens, it becomes difficult to retain the properties as a surfactant, which is problematic.

### Citation List

### Patent Literature

PTL 1: Japanese Unexamined Patent Application Publication No. 10-230154

### Summary of Invention

### Technical Problem

An object of the present invention is to provide a fluorine-based surfactant from which PFOS and PFOA, which tend to accumulate in the environment and living bodies, cannot be structurally generated; even when the fluorine-based surfactant has lower fluorine content than surfactants having a fluoroalkyl group having 8 or more carbon atoms, the fluorine-based surfactant has a high capability of decreasing surface tension that is equal to or higher than that of the surfactants and can be used as a leveling agent. An object of the present invention is to provide a coating composition and a resist composition that include the fluorine-based surfactant.

### Solution to Problem

The inventors of the present invention performed thorough studies and, as a result, have found the following findings. A fluorine-based surfactant that includes a copolymer synthesized by copolymerization between a polymerizable monomer having a poly(perfluoroalkylene ether) chain and polymerizable unsaturated groups such as (meth)acryloyl groups at both ends of the chain and a polymerizable monomer having an oxyalkylene group and a polymerizable unsaturated group has a capability of decreasing surface tension that is equal to or higher than that of normal random copolymers synthesized from a polymerizable monomer having a fluoroalkyl group having 8 or more carbon atoms and a non-fluorine-based polymerizable monomer. The fluorine-based surfactant is effective in that it poses a lower risk in terms of accumulation in the environment and living bodies. Thus, the inventors have accomplished the present invention.

In summary, the present invention relates to a fluorine-based surfactant including a copolymer synthesized by copolymerizing, as essential monomers, a polymerizable monomer (A) having a poly(perfluoroalkylene ether) chain and polymerizable unsaturated groups at both ends of the chain and a polymerizable monomer (B) having an oxyalkylene group and a polymerizable unsaturated group.

The present invention also relates to a coating composition and a resist composition that contain the above-described fluorine-based surfactant.

### Advantageous Effects of Invention

A fluorine-based surfactant according to the present invention has a poly(perfluoroalkylene ether) chain and an oxyalkylene group and, as a result, it sufficiently functions as a surfactant. In addition, the fluorine-based surfactant has no fluoroalkyl group having 8 or more carbon atoms and, as a result, it does not generate PFOS or PFOA and is a safe product that causes less accumulation in the environment and living bodies. Even when the fluorine-based surfactant has lower fluorine content than surfactants having a fluoroalkyl group having 8 or more carbon atoms, it has a higher capability of decreasing surface tension than the surfactants and it can provide an excellent leveling property by addition thereof in a small amount.

Accordingly, the fluorine-based surfactant can be suitably used as a leveling agent for a coating composition or a resist composition. The fluorine-based surfactant exhibits a sufficient leveling property by addition thereof in a small amount and hence it does not degrade properties of the base resin, which is advantageous. By adding a fluorine-based surfactant according to the present invention as a leveling agent to a coating composition or a resist composition, high surface smoothness can be achieved in various coating processes such as spin coating, roll coating, dip coating, spray coating, blade coating, slit coating, curtain coating, and gravure coating.

### Brief Description of Drawings

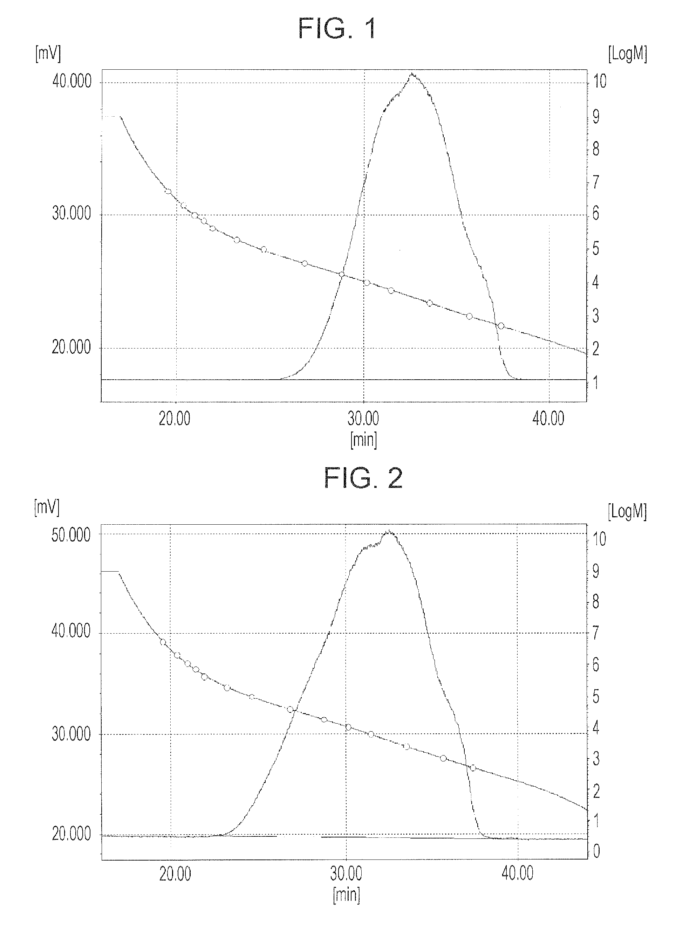

[Fig. 1] Fig. 1 is a GPC chart of a fluorine-based copolymer (1) synthesized in Example 1.
[Fig. 2] Fig. 2 is a GPC chart of a fluorine-based copolymer (2) produced in Example 2.

### Description of Embodiments

A fluorine-based surfactant according to the present invention is a copolymer synthesized by copolymerizing, as essential monomers, a polymerizable monomer (A) having a poly(perfluoroalkylene ether) chain and polymerizable unsaturated groups at both ends of the chain and a polymerizable monomer (B) having an oxyalkylene group and a polymerizable unsaturated group.

The polymerizable monomer (A) is a compound having a poly(perfluoroalkylene ether) chain and polymerizable unsaturated groups at both ends of the chain.

The poly(perfluoroalkylene ether) chain may have a structure in which a bivalent fluorocarbon group having 1 to 3 carbon atoms and an oxygen atom are alternately linked. The divalent fluorocarbon group having 1 to 3 carbon atoms may be alone or in combination of two or more thereof. Specifically, the divalent fluorocarbon group may be represented by the following structural formula (a1).

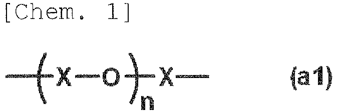

(In the structural formula (a1), X's represent the following structural formulae (a1-1) to (a1-5); all X's in the structural formula (a1) may have the same structure or a plurality of structures may be present randomly or in blocks. n represents the number of the repeating unit and an integer of 1 or more.)

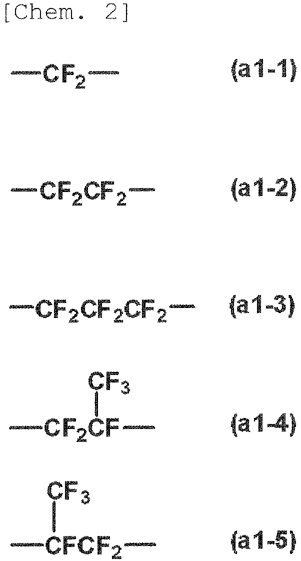

Of these, presence of both the perfluoromethylene structure represented by the structural formula (a1-1) and the perfluoroethylene structure represented by the structural formula (a1-2) is particularly preferred because a coating composition containing a fluorine-based surfactant according to the present invention has a high leveling property and a smooth coating film can be obtained. Here, the presence ratio of the perfluoromethylene structure represented by the structural formula (a1-1) to the perfluoroethylene structure represented by the structural formula (a1-2) preferably satisfies a molar ratio [structure (a1-1)/structure(a1-2)] being in the range of 1/10 to 10/1 in view of the leveling property. In the structural formula (a1), n is preferably in the range of 3 to 100, in particular, in the range of 6 to 70.

In the poly(perfluoroalkylene ether) chain, the total number of fluorine atoms in a single poly(perfluoroalkylene ether) chain is preferably in the range of 18 to 200, more preferably in the range of 25 to 150 because the leveling property of the coating composition and dissolubility in non-fluorine-based material in the coating composition can be both achieved.

Examples of a compound to which polymerizable unsaturated groups are to be introduced into both ends, the compound serving as a raw material of the polymerizable monomer (A), include general formulae (a2-1) to (a2-6) below. In the following structural formulae, "-PFPE-" represents the above-described poly(perfluoroalkylene ether) chain.

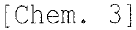

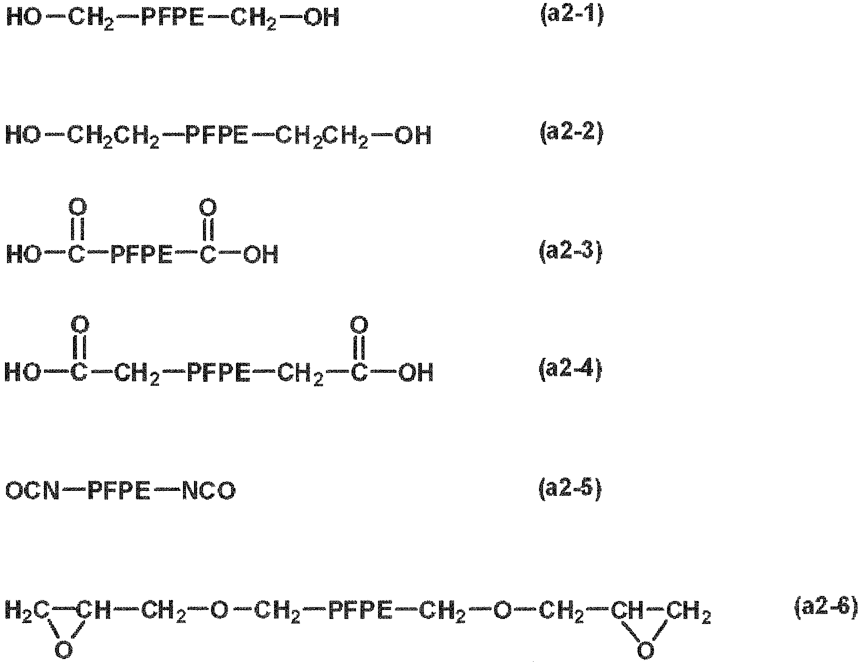

Examples of the polymerizable unsaturated groups at both ends of the poly(perfluoroalkylene ether) chain of the polymerizable monomer (A) include polymerizable unsaturated groups represented by the following structural formulae U-1 to U-5.

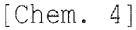

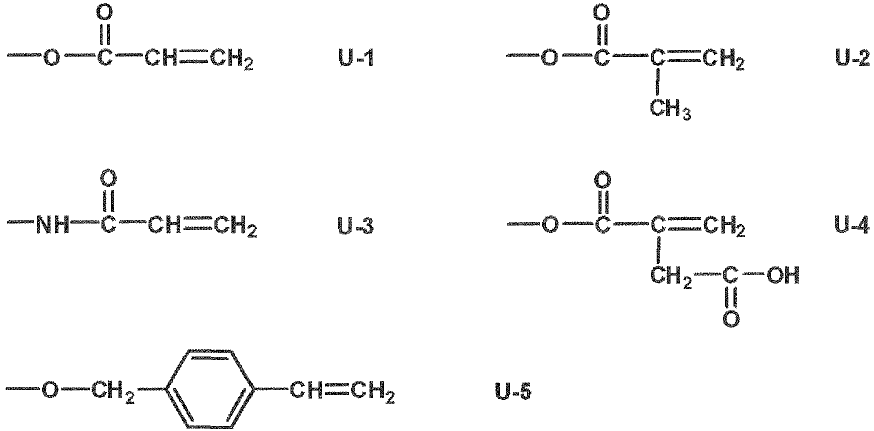

Among these polymerizable unsaturated groups, the acryloyloxy group represented by the structural formula U-1 and the methacryloyloxy group represented by the structural formula U-2 are particularly preferred in view of ease of availability or production of the polymerizable monomer (A) itself or ease of copolymerization with the polymerizable monomer (B) described below.

Examples of a method for producing the polymerizable monomer (A) is as follows: a compound in which a hydroxy group is present at each end of a poly(perfluoroalkylene ether) chain is subjected to a dehydrochlorination reaction with (meth)acrylic acid chloride, a dehydration reaction with (meth)acrylic acid, a urethanization reaction with 2-(meth)acryloyloxyethyl isocyanate, an esterification reaction with itaconic anhydride, or a reaction with styrene having a chloromethyl group in the presence of a base; a compound in which a carboxyl group is present at each end of a poly(perfluoroalkylene ether) chain is subjected to an esterification reaction with 4-hydroxybutyl acrylate glycidyl ether or an esterification reaction with glycidyl (meth)acrylate; or a compound in which an isocyanate group is present at each end of a poly(perfluoroalkylene ether) chain is subjected to a reaction with 2-hydroxyethyl (meth)acrylate to introduce the 2-hydroxyethyl (meth)acrylate or a reaction with 2-hydroxyethyl (meth)acrylamide. Among these, the following methods are particularly preferred because the polymerizable monomer (A) is easily synthesized: a compound in which a hydroxy group is present at each end of a poly(perfluoroalkylene ether) chain is subjected to a dehydrochlorination reaction with (meth)acrylic acid chloride and a urethanization reaction with 2-(meth)acryloyloxyethyl isocyanate.

Note that, in the present invention, "(meth)acryloyl group" denotes one or both of a methacryloyl group and an acryloyl group; "(neth)acrylate" denotes one or both of methacrylate and acrylate; "(meth)acrylic acid" denotes one or both of methacrylic acid and acrylic acid.

Specific examples of the polymerizable monomer (A) include those represented by structural formulae (A-1) to (A-13) below. Note that "-PFPE-" in the following structural formulae represents a poly(perfluoroalkylene ether) chain.

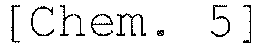

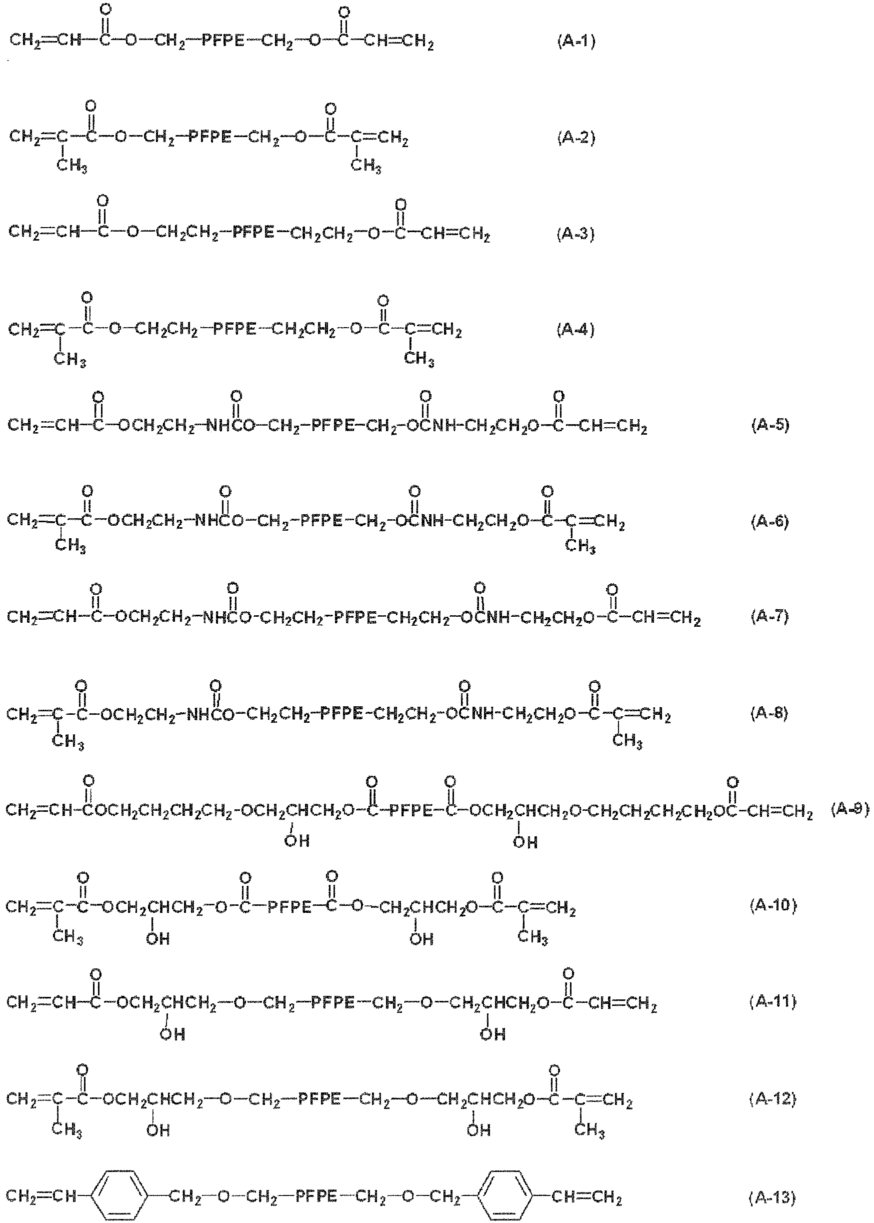

Of these, in view of ease of industrial production of the polymerizable monomer (A), those represented by the structural formulae (A-1), (A-2), (A-5), and (A-6) are preferred; more preferred is the monomer represented by the structural formula (A-1) in which an acryloyl group is present at each end of the poly(perfluoroalkylene ether) chain because the performance as a leveling agent can be further enhanced.

The polymerizable monomer (B) has an oxyalkylene group and a polymerizable unsaturated group. Examples of the polymerizable unsaturated group in the polymerizable monomer (B) include a (meth)acryloyl group, a vinyl group, and a maleimide group. In view of ease of copolymerization with the polymerizable monomer (A), the (meth)acryloyl group is preferred.

Specific examples of the polymerizable monomer (B) include monomers represented by the following general formula (B1).

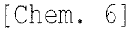

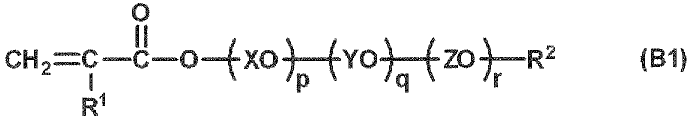

(In the formula, R¹ represents a hydrogen atom or a methyl group; X, Y, and Z each independently represent an alkylene group; p, q, and r each represent an integer of 0 or 1 or more; the total of p, q, and r is an integer of 1 or more; and R² represents a hydrogen atom or an alkyl group having 1 to 6 carbon atoms.)

In the general formula (B1), X, Y, and Z represent alkylene groups. These alkylene groups may include substituted alkylene groups. Specific examples of the -O-(XO)ₚ-(YO)_{q}-(ZO)ᵣ- moiety include an ethylene glycol residue where the repeating-unit number p is 1, q and r are 0, and X represents ethylene; a propylene glycol residue where the repeating-unit number p is 1, q and r are 0, and X represents propylene; a butylene glycol residue where the repeating-unit number p is 1, q and r are 0, and X represents butylene; and polyalkylene glycol residues such as a polyethylene glycol residue where the repeating-unit number p is an integer of 2 or more, q and r are 0, and X represents ethylene; a polypropylene glycol residue where the repeating-unit number p is an integer of 2 or more, q and r are 0, and X represents 1-methylethylene (propylene); an ethylene oxide-propylene oxide copolymer residue where the repeating-unit numbers p and q are both integers of 1 or more, r is 0, and one of X and Y represents ethylene and the other one represents 1-methylethylene (propylene); and an ethylene oxide-propylene oxide copolymer residue where the repeating-unit numbers p, q, and r are integers of 1 or more, and X and Z represent ethylene and Y represents 1-methylethylene (propylene).

The degree of polymerization of the polyalkylene glycol, that is, the total of p, q, and r in the general formula (B1) is preferably 1 to 80, more preferably 3 to 50. Note that the repeating unit including X, the repeating unit including Y, and the repeating unit including Z may be distributed randomly or in blocks.

R² in the general formula (B1) represents hydrogen or an alkyl group having 1 to 6 carbon atoms. When R² represents hydrogen, the polymerizable monomer (B) is mono(meth)acrylate of an alkylene glycol such as polyethylene glycol, polypropylene glycol, or polybutylene glycol. When R² has 1 to 6 carbon atoms, an end of mono(meth)acrylate of an alkylene glycol, the end not being the (meth)acrylate, is capped with the alkyl group having 1 to 6 carbon atoms.

More specifically, examples of the monomer (B1) include polypropylene glycol mono(meth)acrylate, polyethylene glycol mono(meth)acrylate, polytetramethylene glycol (meth)acrylate, poly(ethylene glycol·propylene glycol) mono(meth)acrylate, polyethylene glycol·polypropylene glycol mono(meth)acrylate, poly(ethylene glycol·tetramethylene glycol) mono(meth)acrylate, polyethylene glycol·polytetramethylene glycol mono(meth)acrylate, poly(propylene glycol·tetramethylene glycol) mono(meth)acrylate, polypropylene glycol·polytetramethylene glycol mono(meth)acrylate, poly(propylene glycol·butylene glycol) mono(meth)acrylate, polypropylene glycol·polybutylene glycol mono(meth)acrylate, poly(ethylene glycol·butylene glycol) mono(meth)acrylate, polyethylene glycol·polybutylene glycol mono(meth)acrylate, poly(tetraethylene glycol·butylene glycol) mono(meth)acrylate, polytetraethylene glycol·polybutylene glycol mono(meth)acrylate, polybutylene glycol mono(meth)acrylate, poly(ethylene glycol·trimethylene glycol) mono(meth)acrylate, polyethylene glycol·polytrimethylene glycol mono(meth)acrylate, poly(propylene glycol·trimethylene glycol) mono(meth)acrylate, polypropylene glycol·polytrimethylene glycol mono(meth)acrylate, poly(trimethylene glycol·tetramethylene glycol) mono(meth)acrylate, polytrimethylene glycol·polytetramethylene glycol mono(meth)acrylate, poly(butylene glycol·trimethylene glycol) mono(meth)acrylate, and polybutylene glycol·polytrimethylene glycol mono(meth)acrylate. Note that "poly(ethylene glycol·propylene glycol)" means a random copolymer between ethylene glycol and propylene glycol; "polyethylene glycol·polypropylene glycol" means a block copolymer between ethylene glycol and propylene glycol. This is also the case for the other monomers. Among the monomers (B1), polypropylene glycol mono(meth)acrylate, polyethylene glycol mono(meth)acrylate, and polyethylene glycol·polypropylene glycol mono(meth)acrylate are preferred because they have high compatibility with other components in a coating composition according to the present invention.

Examples of commercially available products of the monomer (B1) include "NK ester M-20G", "NK ester M-40G", "NK ester M-90G", "NK ester M-230G", "NK ester AM-90G", "NK ester AMP-10G", "NK ester AMP-20G", and "NK ester AMP-60G" that are manufactured by Shin Nakamura Chemical Co., Ltd.; and "BLEMMER PE-90", "BLEMMER PE-200", "BLEMMER PE-350", "BLEMMER PME-100", "BLEMMER PME-200", "BLEMMER PME-400", "BLEMMER PME-4000"_{,} "BLEMMER PP-1000", "BLEMMER PP-500", "BLEMMER PP-800", "BLEMMER 70PEP-350B", "BLPMMER 55PET-800", "BLEMMER 50POEP-800B", "BLEMMER 10PPB-500B", "BLEMMER NKH-5050", "BLEMMER AP-400", and "BLEMMER AE-350" that are manufactured by NOF CORPORATION. These monomers (B1) may be used alone or in combination of two or more thereof.

Starting materials of a fluorine-based surfactant according to the present invention are, as essential components, the polymerizable monomer (A) and the polymerizable monomer (B). Another polymerizable monomer, alkyl (meth)acrylate (C), may be additionally used as a starting material. Specific examples of the alkyl (meth)acrylate (C) are represented by the following general formula (C1).

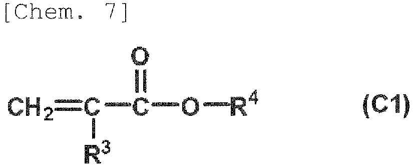

(In the formula, R³ represents a hydrogen atom or a methyl group; and R⁴ represents a linear, branched, or cyclic alkyl group having 1 to 18 carbon atoms.)

R⁴ in the general formula (C1) represents a linear, branched, or cyclic alkyl group having 1 to 18 carbon atoms. This alkyl group may have a substituent such as an aliphatic or aromatic hydrocarbon group or a hydroxy group. More specifically, examples of the alkyl (meth)acrylate (C) include C₁₋₁₈ alkyl esters of (meth)acrylic acid such as methyl (meth)acrylate, ethyl (meth)acrylate, propyl (meth)acrylate, butyl (meth)acrylate, octyl (meth)acrylate, 2-ethylhexyl (meth)acrylate, decyl (meth)acrylate, dodecyl (meth)acrylate, and stearyl (meth)acrylate; and C₁₋₁₈ bridged cycloalkyl esters of (meth)acrylic acid such as dicyclopentanyloxylethyl (meth)acrylate, isobornyloxylethyl (meth)acrylate, isobornyl (meth)acrylate, adamantyl (meth)acrylate, dimethyladamantyl (meth)acrylate, dicyclopentanyl (meth)acrylate, and dicyclopentenyl (meth)acrylate. These polymerizable monomers (C) may be used alone or in combination of two or more thereof.

Other usable starting materials of a fluorine-based surfactant according to the present invention, that is, polymerizable monomers other than the polymerizable monomers (A), (B), and (C) include aromatic vinyl compounds such as styrene, α-methyl styrene, p-methyl styrene, and p-methoxy styrene; and maleimide compounds such as maleimide, methylmaleimide, ethylmaleimide, propylmaleimide, butylmaleimide, hexylmaleimide, octylmaleimide, dodecylmaleimide, stearylmaleimide, phenylmaleimide, and cyclohexylmaleimide. In addition, for example, a polymerizable monomer having a fluoroalkyl group having 1 to 6 carbon atoms may be used.

A method for producing a fluorine-based surfactant according to the present invention is not particularly limited. For example, the polymerizable monomer (A), the polymerizable monomer (B), optionally another polymerizable monomer are polymerized with a radical polymerization initiator in an organic solvent. Preferred examples of the organic solvent used here include ketones, esters, amides, sulfoxides, ethers, and hydrocarbons: specifically, acetone, methyl ethyl ketone, methyl isobutyl ketone, cyclohexanone, ethyl acetate, butyl acetate, propylene glycol monomethyl ether acetate, dimethylformamide, dimethylacetamide, N-methylpyrrolidone, dimethyl sulfoxide, diethyl ether, diisopropyl ether, tetrahydrofuran, dioxane, toluene, and xylene. These may be appropriately selected in accordance with the boiling point, compatibility, and polymerizability. Examples of the radical polymerization initiator include peroxides such as benzoyl peroxide and azo compounds such as azobisisobutyronitrile. If necessary, a chain transfer agent such as lauryl mercaptan, 2-mercaptoethanol, thioglycerol, ethylthioglycolic acid, and octylthioglycolic acid may also be used.

To exhibit high compatibility with other components in a resin composition such as a coating composition and to provide a high leveling property, a fluorine-based surfactant according to the present invention preferably has a number-average molecular weight (Mn) in the range of 500 to 20,000, more preferably in the range of 1,500 to 10,000; and a weight-average molecular weight (Mw) in the range of 2,000 to 100,000, more preferably in the range of 3,000 to 50,000. Note that the number-average molecular weight (Mn) and the weight-average molecular weight (Mw) are calculated in terms of polystyrene on the basis of measurements by gel permeation chromatography (hereafter, abbreviated as "GPC"). The GPC measurement conditions are as follows.

### [GPC measurement conditions]

Measurement apparatus: "HLC-8220 GPC" manufactured by Tosoh Corporation
Columns: guard column "HHR-H" (6.0 mm I.D. x4 cm) manufactured by Tosoh Corporation
+ "TSK-GEL GMHHR-N" (7.8 mm I.D. x30 cm) manufactured by Tosoh Corporation
+ "TSK-GEL GMHHR-N" (7.8 mm I.D. x30 cm) manufactured by Tosoh Corporation
+ "TSK-GEL GMHHR-N" (7.8 mm I.D. ×30 cm) manufactured by Tosoh Corporation
+ "TSK-GEL GMHHR-N" (7.8 mm I.D. x30 cm) manufactured by Tosoh Corporation
Detector: ELSD ("ELSD2000" manufactured by Alltech associates, Inc.)
Data processing: "GPC-8020 Model II data analysis version 4.30" manufactured by Tosoh Corporation
Measurement conditions: Column temperature 40°C
   Developing solvent tetrahydrofuran (THF)
   Flow rate 1.0 ml/min
Sample: 1.0% by mass tetrahydrofuran solution (5 µl) in terms of resin solid content prepared by filtration through a microfilter
Standard sample: The following monodisperse polystyrenes having a known molecular weight were used in conformity with the measurement manual of the "GPC-8020 Model II data analysis version 4.30".

### (Monodisperse polystyrenes)

"A-500" manufactured by Tosoh Corporation
"A-1000" manufactured by Tosoh Corporation
"A-2500" manufactured by Tosoh Corporation
"A-5000" manufactured by Tosoh Corporation
"F-1" manufactured by Tosoh Corporation
"F-2" manufactured by Tosoh Corporation
"F-4" manufactured by Tosoh Corporation
"F-10" manufactured by Tosoh Corporation
"F-20" manufactured by Tosoh Corporation
"F-40" manufactured by Tosoh Corporation
"F-80" manufactured by Tosoh Corporation
"F-128" manufactured by Tosoh Corporation
"F-288" manufactured by Tosoh Corporation
"F-550" manufactured by Tosoh Corporation

To allow a sufficient leveling property of a coating composition or a resist composition and to achieve high compatibility with other components in a coating composition or a resist composition, the total fluorine content in the polymerizable monomer (A), the polymerizable monomer (B), and optional other polymerizable monomers that serve as starting materials of a fluorine-based surfactant according to the present invention is preferably in the range of 2% to 40% by mass, more preferably in the range of 5% to 30% by mass, still more preferably in the range of 10% to 25% by mass. Note that the fluorine content is calculated as the mass ratio of fluorine atoms with respect to the total mass of the polymerizable monomers used as the starting materials of a fluorine-based surfactant according to the present invention.

A coating composition according to the present invention contains, as an additive, the above-described fluorine-based surfactant according to the present invention. The amount of the fluorine-based surfactant added to the coating composition varies in accordance with, for example, the type of the coating resin, a coating process, or a target film thickness. The amount with respect to 100 parts by mass of the solid content of the coating composition is preferably 0.0001 to 10 parts by mass, more preferably 0.001 to 5 parts by mass, still more preferably 0.01 to 2 parts by mass. When the amount of the fluorine-based surfactant added satisfies such a range, the surface tension can be sufficiently decreased, an intended leveling property can be achieved, and disadvantages such as foaming during coating can be suppressed.

By using a fluorine-based surfactant according to the present invention as an additive for a coating composition, a coating composition can be provided that causes less accumulation in the environment and living bodies than existing fluorine-based surfactants having a perfluoroalkyl group having 8 or more carbon atoms and that, even in the case of having a lower fluorine content, has a leveling property equal to or higher than that of existing fluorine-based surfactants having a perfluoroalkyl group having 8 or more carbon atoms. Examples of such a coating composition include various paint compositions and photosensitive resin compositions.

Examples of the paint compositions include paints employing natural resins such as petroleum-resin paints, shellac paints, rosin-based paints, cellulose-based paints, rubber-based paints, Japanese-lacquer paints, cashew-gum paints, and oil-based vehicle paints; and paints employing synthetic resins such as phenol-resin paints, alkyd-resin paints, unsaturated-polyester-resin paints, amino-resin paints, epoxy-resin paints, vinyl-resin paints, acrylic-resin paints, polyurethane-resin paints, silicone-resin paints, and fluorocarbon-resin paints.

A fluorine-based surfactant according to the present invention may be applied not only to the paint compositions listed as examples but also to active-energy-ray-curable compositions. Such an active-energy-ray-curable composition contains, as a main component, an active-energy-ray-curable resin or an active-energy-ray-curable monomer. Note that the active-energy-ray-curable resin and the active-energy-ray-curable monomer may be used alone or in combination.

Examples of the active-energy-ray-curable resin include urethane (meth)acrylate resins, unsaturated polyester resins, epoxy (meth)acrylate resins, polyester (meth)acrylate resins, acrylic (meth)acrylate resins, and resins having a maleimide group. In the present invention, in particular, urethane (meth)acrylate resins are preferred in view of, for example, transparency and low shrinkage.

Such a urethane (meth)acrylate resin used herein may be a resin that has a urethane bond and a (meth)acryloyl group and is obtained by a reaction between an aliphatic polyisocyanate compound or an aromatic polyisocyanate compound and a (meth)acrylate compound having a hydroxy group.

Examples of the aliphatic polyisocyanate compound include tetramethylene diisocyanate, pentamethylene diisocyanate, hexamethylene diisocyanate, heptamethylene diisocyanate, octamethylene diisocyanate, decamethylene diisocyanate, 2-methyl-1,5--pentane diisocyanate, 3-methyl-1,5-pentane diisocyanate, dodecamethylene diisocyanate, 2-methylpentamethylene diisocyanate, 2,2,4-trimethylhexamethylene diisocyanate, 2,4,4-trimethylhexamethylene diisocyanate, isophorone diisocyanate, norbornane diisocyanate, hydrogenated diphenylmethane diisocyanate, hydrogenated tolylene diisocyanate, hydrogenated xylylene diisocyanate, hydrogenated tetramethylxylylene diisocyanate, and cyclohexyl diisocyanate. Examples of the aromatic polyisocyanate compound include tolylene diisocyanate, 4,4'-diphenylmethane diisocyanate, xylylene diisocyanate, 1,5-naphthalene diisocyanate, tolidine diisocyanate, and p-phenylene diisocyanate.

On the other hand, examples of the acrylate compound having a hydroxy group include 2-hydroxyethyl (meth)acrylate, 2-hydroxypropyl (meth)acrylate, 2-hydroxybutyl (meth)acrylate, 4-hydroxybutyl (meth)acrylate, dihydric alcohol mono(meth)acrylates such as 1,5-pentanediol mono(meth)acrylate, 1,6-hexanediol mono(meth)acrylate, neopentyl glycol mono(meth)acrylate, and hydroxypivalate neopentyl glycol mono(meth)acrylate; trihydric alcohol mono/di(meth)acrylates such as trimethylolpropane di(meth)acrylate, ethoxylated trimethylolpropane (meth)acrylate, propoxylated trimethylolpropane di(meth)acrylate, glycerin di(meth)acrylate, and bis(2-(meth)acryloyloxyethyl)hydroxyethylisocyanurate, and mono/di(meth)acrylates having a hydroxy group provided by modifying a part of alcoholic hydroxy groups of the foregoing with ε-caprolactone; compounds having a single hydroxy group and three or more (meth)acryloyl groups such as pentaerythritol tri(meth)acrylate, ditrimethylolpropane tri(meth)acrylate, and dipentaerythritol penta(meth)acrylate, and polyfunctional (meth)acrylates having a hydroxy group provided by modifying the compounds with ε-caprolactone; (meth)acrylate compounds having an oxyalkylene chain such as dipropylene glycol mono(meth)acrylate, diethylene glycol mono(meth)acrylate, polypropylene glycol mono(meth)acrylate, and polyethylene glycol mono(meth)acrylate; (meth)acrylate compounds having block oxyalkylene chains such as polyethylene glycol-polypropylene glycol mono(meth)acrylate and polyoxybutylene-polyoxypropylene mono(meth)acrylate; and (meth)acrylate compounds having random oxyalkylene chains such as poly(ethylene glycol-tetramethylene glycol) mono(meth)acrylate and poly(propylene glycol-tetramethylene glycol) mono(meth)acrylate.

The reaction between an aliphatic polyisocyanate compound or an aromatic polyisocyanate compound and an acrylate compound having a hydroxy group can be conducted in a standard manner in the presence of a urethane-forming catalyst. Specific examples of a urethane-forming catalyst usable herein include amines such as pyridine, pyrrole, triethylamine, diethylamine, and dibutylamine; phosphines such as triphenylphosphine and triethylphosphine; organic tin compounds such as dibutyl tin dilaurate, octyl tin trilaurate, octyl tin diacetate, dibutyl tin diacetate, and tin octylate; and organic metal compounds such as zinc octylate.

Of the urethane acrylate resins, in particular, preferred are resins obtained through a reaction between an aliphatic polyisocyanate compound and a (meth)acrylate compound having a hydroxy group because the cured coating films have high transparency and the resins have high sensitivity to active energy rays and high curability.

Next, such an unsaturated polyester resin is a curable resin obtained through polycondensation between an α,β-unsaturated dibasic acid, an acid anhydride thereof, an aromatic saturated dibasic acid, or an acid anhydride thereof, and a glycol. Examples of the α,β-unsaturated dibasic acid or the acid anhydride thereof include maleic acid, maleic anhydride, fumaric acid, itaconic acid, citraconic acid, chloromaleic acid, and esters of the foregoing. Examples of the aromatic saturated dibasic acid or the acid anhydride thereof include phthalic acid, phthalic anhydride, isophthalic acid, terephthalic acid, nitrophthalic acid, tetrahydrophthalic anhydride, endomethylene tetrahydrophthalic anhydride, halogenated phthalic anhydrides, and esters of the foregoing. Examples of an aliphatic or alicyclic saturated dibasic acid include oxalic acid, malonic acid, succinic acid, adipic acid, sebacic acid, azelaic acid, glutaric acid, hexahydrophthalic anhydride, and esters of the foregoing. Examples of the glycol include ethylene glycol, propylene glycol, diethylene glycol, dipropylene glycol, 1,3-butanediol, 1,4-butanediol, 2-methylpropane-1,3-diol, neopentyl glycol, triethylene glycol, tetraethylene glycol, 1,5-pentanediol, 1,6-hexanediol, bisphenol A, hydrogenated bisphenol A, ethylene glycol carbonate, and 2,2-di-(4-hydroxypropoxydiphenyl)propane; and an oxide such as ethylene oxide or propylene oxide may be similarly used.

Next, examples of an epoxy vinyl ester resin include resins obtained through a reaction between (meth)acrylic acid and an epoxy group of an epoxy resin such as a bisphenol A epoxy resin, a bisphenol F epoxy resin, a phenol-novolac epoxy resin, or a cresol-novolac epoxy resin.

Examples of the resins having a maleimide group include a bifunctional maleimide urethane compound obtained by urethane formation between N-hydroxyethylmaleimide and isophorone diisocyanate; a bifunctional maleimide ester compound obtained by ester formation between maleimide acetic acid and polytetramethylene glycol; a tetrafunctional maleimide ester compound obtained by ester formation between maleimide caproic acid and a tetraethylene oxide adduct of pentaerythritol; and a polyfunctional maleimide ester compound obtained by ester formation between maleimide acetic acid and a polyhydric alcohol compound. Such active-energy-ray-curable resins may be used alone or in combination of two or more thereof.

Examples of the active-energy-ray-curable monomer include ethylene glycol di(meth)acrylate, diethylene glycol di(meth)acrylate, triethylene glycol di(meth)acrylate, polyethylene glycol di(meth)acrylate having a number-average molecular weight in the range of 150 to 1000, propylene glycol di(meth)acrylate, dipropylene glycol di(meth)acrylate, tripropylene glycol di(meth)acrylate, polypropylene glycol di(meth)acrylate having a number-average molecular weight in the range of 150 to 1000, neopentyl glycol di(meth)acrylate, 1,3-butanediol di(meth)acrylate, 1,4-butanediol di(meth)acrylate, 1,6-hexanediol di(meth)acrylate, hydroxypivalic acid ester neopentyl glycol di(meth)acrylate, bisphenol A di(meth)acrylate, trimethylolpropane tri(meth)acrylate, pentaerythritol tri(meth)acrylate, dipentaerythritol hexa(meth)acrylate, pentaerythritol tetra(meth)acrylate, trimethylolpropane di(meth)acrylate, dipentaerythritol penta(meth)acrylate, dicyclopentenyl (meth)acrylate; aliphatic alkyl (meth)acrylates such as methyl (meth)acrylate, propyl (meth)acrylate, butyl (meth)acrylate, t-butyl (meth)acrylate, 2-ethylhexyl (meth)acrylate, octyl (meth)acrylate, decyl (meth)acrylate, isodecyl (meth)acrylate, lauryl (meth)acrylate, stearyl (meth)acrylate, and isostearyl (meth)acrylate; glycerol (meth)acrylate, 2-hydroxyethyl (meth)acrylate, 3-chloro-2-hydroxypropyl (meth)acrylate, glycidyl (meth)acrylate, allyl (meth)acrylate, 2-butoxyethyl (meth)acrylate, 2-(diethylamino)ethyl (meth)acrylate, 2-(diethylamino)ethyl (meth)acrylate, γ-(meth)acryloxypropyltrimethoxysilane, 2-methoxyethyl (meth)acrylate, methoxydiethylene glycol (meth)acrylate, methoxydipropylene glycol (meth)acrylate, nonylphenoxypolyethylene glycol (meth)acrylate, nonylphenoxypolypropylene glycol (meth)acrylate, phenoxyethyl (meth)acrylate, phenoxydipropylene glycol (meth)acrylate, phenoxypolypropylene glycol (meth)acrylate, polybutadiene (meth)acrylate, polyethylene glycol-polypropylene glycol (meth)acrylate, polyethylene glycolpolybutylene glycol (meth)acrylate, polystyrylethyl (meth)acrylate, benzyl (meth)acrylate, cyclohexyl (meth)acrylate, dicyclopentanyl (meth)acrylate, dicyclopentenyl (meth)acrylate, isobornyl (meth)acrylate, methoxylated cyclodecatriene (meth)acrylate, phenyl (meth)acrylate; and maleimides such as maleimide, N-methylmaleimide, N-ethylmaleimide, N-propylmaleimide, N-butylmaleimide, N-hexylmaleimide, N-octylmaleimide, N-dodecylmaleimide, N-stearylmaleimide, N-phenylmaleimide, N-cyclohexylmaleimide, 2-maleimideethyl-ethylcarbonate, 2-maleimideethyl-propylcarbonate, N-ethyl-(2-maleimideethyl)carbamate, N.N-hexamethylenebismaleimide, polypropylene glycol-bis(3-maleimidepropyl) ether, bis(2-maleimideethyl) carbonate, and 1,4-dimaleimidecyclohexane.

Of these, in particular, preferred are polyfunctional (meth)acrylates having a functionality of three or more such as trimethylolpropane tri(meth)acrylate, pentaerythritol tri(meth)acrylate, dipentaerythritol hexa(meth)acrylate, and pentaerythritol tetra(meth)acrylate because cured coating films having high hardness are provided. Such active-energy-ray-curable monomers may be used alone or in combination of two or more thereof.

By applying the active-energy-ray-curable composition to a base material and then irradiating the applied composition with an active energy ray, a cured coating film can be formed. The active energy ray denotes an ionizing radiation such as ultraviolet rays, electron beams, α-rays, β-rays, or γ-rays. When such a cured coating film is formed through irradiation with ultraviolet rays serving as an active energy ray, a photopolymerization initiator is preferably added to the curable fluorine-containing resin or the active-energy-ray-curable composition to enhance the curability. If necessary, a photosensitizer may be further added to enhance the curability. On the other hand, when an ionizing radiation such as electron beams, α-rays, β-rays, or γ-rays is used, rapid curing is achieved without use of a photopolymerization initiator or a photosensitizer and hence it is not necessary to add a photopolymerization initiator or a photosensitizer.

The photopolymerization initiator may be an intramolecular-cleavage photopolymerization initiator or a hydrogen-abstraction photopolymerization initiator. Examples of the intramolecular-cleavage photopolymerization initiator include acetophenone-based compounds such as diethoxyacetophenone, 2-hydroxy-2-methyl-1-phenylpropane-1-one, benzyl dimethyl ketal, 1-(4-isopropylphenyl)-2-hydroxy-2-methylpropane-1-one, 4-(2-hydroxyethoxy)phenyl-(2-hydroxy-2-propyl) ketone, 1-hydroxycyclohexyl-phenyl ketone, 2-methyl-2-morpholino(4-thiomethylphenyl)propane-1-one, and 2-benzyl-2-dimethylamino-1-(4-morpholinophenyl)-butanone; benzoins such as benzoin, benzoin methyl ether, and benzoin isopropyl ether; acylphosphine oxide-based compounds such as 2,4,6-trimethylbenzoin diphenylphosphine oxide and bis(2,4,6-trimethylbenzoyl)-phenylphosphine oxide; and benzil and methylphenylglyoxy ester.

On the other hand, examples of the hydrogen-abstraction photopolymerization initiator include benzophenone-based compounds such as benzophenone, o-benzoyl methylbenzoate-4-phenylbenzophenone, 4,4'-dichlorobenzophenone, hydroxybenzophenone, 4-benzoyl-4'-methyl-diphenylsulfide, acrylate benzophenone, 3,3',4,4'-tetra(t-butylperoxycarbonyl)benzophenone, and 3,3'-dimethyl-4-methoxybenzophenone; thioxanthone-based compounds such as 2-isopropylthioxanthone, 2,4-dimethylthioxanthone, 2,4-diethylthioxanthone, and 2,4-dichlorothioxanthone; aminobenzophenone-based compounds such as Michler's ketone and 4,4'-diethylaminobenzophenone; 10-butyl-2-chloroacridone, 2-ethylanthraquinone, 9,10-phenanthrenequinone, and camphorquinone.

Of the above-described photopolymerization initiators, in view of high compatibility with the active-energy-ray-curable resin and the active-energy-ray-curable monomer in the active-energy-ray-curable paint composition, 1-hydroxycyclohexyl phenyl ketone and benzophenone are preferred, in particular, 1-hydroxycyclohexyl phenyl ketone is preferred. Such photopolymerization initiators may be used alone or in combination of two or more thereof.

Examples of the photosensitizer include amines such as aliphatic amines and aromatic amines; ureas such as o-tolylthio urea; and sulfur compounds such as sodium diethyldithiophosphate and s-benzylisothiuronium-p-toluenesulfonate.

The amounts of the photopolymerization initiator and the photosensitizer used are each preferably 0.01 to 20 parts by mass, more preferably 0.1% to 15% by mass, still more preferably 0.3 to 7 parts by mass with respect to 100 parts by mass of the nonvolatile components in the active-energy-ray-curable composition.

If necessary, the paint composition may be appropriately used in combination with various additives. Examples of the additives include organic solvents; coloring agents such as pigments, dyes, and carbon; inorganic powders of silica, titanium oxide, zinc oxide, aluminum oxide, zirconium oxide, calcium oxide, and calcium carbonate; fine powders of various resins such as higher fatty acids, acrylic resins, phenol resins, polyester resins, polystyrene resins, urethane resins, urea resins, melamine resins, alkyd resins, epoxy resins, polyamide resins, polycarbonate resins, petroleum resins, and fluorocarbon resins (PTFE (polytetrafluoroethylene) etc.), polyethylene, and polypropylene; antistatic agents, antifoaming agents, viscosity modifiers, light stabilizers, weathering stabilizers, thermal stabilizers, antioxidants, anticorrosives, slip additives, waxes, luster adjusters, release agents, compatibilizers, conductivity adjusting agents, dispersing agents, dispersion stabilizers, thickeners, anti-settling agents, silicone-based surfactants, and hydrocarbon-based surfactants.

The organic solvents are advantageous for appropriately adjusting the viscosity of the solution of the paint composition. In particular, use of such an organic solvent facilitates control of the film thickness in thin-film coating. Examples of the organic solvents usable herein include aromatic hydrocarbons such as toluene and xylene; alcohols such as methanol, ethanol, isopropanol, and t-butanol; esters such as ethyl acetate and propylene glycol monomethyl ether acetate; and ketones such as methyl ethyl ketone, methyl isobutyl ketone, and cyclohexanone. These solvents may be used alone or in combination of two or more thereof.

A coating process for the paint composition varies in accordance with the application. Examples of the coating process include application processes employing a gravure coater, a roll coater, a comma coater, a knife coater, an air knife coater, a curtain coater, a kiss coater, a shower coater, a wheeler coater, a spin coater, dipping, screen printing, spraying, an applicator, a bar coater, and electrostatic coating; and molding processes employing various molds.

Such a photosensitive resin composition upon exposure to light such as visible light or ultraviolet light undergoes alteration of a property of the resin such as solubility, viscosity, transparency, refractive index, conductivity, or ion permeability. Among the photosensitive resin compositions, resist compositions (for example, photoresist compositions and color resist compositions for color filters) are required to have a high leveling property. In general, in photolithography relating to semiconductor or liquid crystal, resist compositions are applied by spin-coating to a thickness about 1 to about 2 µm onto silicon wafers or glass substrates on which various metals have been deposited. At this time, variations in the thickness of the applied films can cause degradation of the quality or defects in the semiconductors or liquid crystal elements. However, when a fluorine-based surfactant according to the present invention is used as an additive for such a photosensitive resin composition, this composition has a high leveling property and allows formation of uniform coating films. Accordingly, for example, the productivity and functions of semiconductors or liquid crystal elements can be enhanced.

In general, a photoresist composition contains a surfactant and a photoresist agent. This photoresist agent contains (1) an alkali-soluble resin, (2) a radiation-sensitive substance (photosensitive substance), (3) a solvent, and optionally (4) another additive.

The alkali-soluble resin (1) used for a resist composition according to the present invention is a resin that is soluble in an alkaline solution used as a developer for patterning the resist. Examples of the alkali-soluble resin include novolac resins synthesized by condensation between at least one selected from aromatic hydroxy compounds such as phenol, cresol, xylenol, resorcinol, phloroglucinol, and hydroquinone and alkyl-substituted or halogen-substituted aromatic compounds of the foregoing and an aldehyde compound such as formaldehyde, acetaldehyde, or benzaldehyde; polymers or copolymers of a vinylphenol compound such as o-vinylphenol, m-vinylphenol, p-vinylphenol, or α-methylvinylphenol, or a halogen-substituted compound of the foregoing; acrylic-acid-based or methacrylic-acid-based polymers or copolymers of acrylic acid, methacrylic acid, hydroxyethyl (meth)acrylate, or the like; polyvinyl alcohol; and modified resins in which a radiation-sensitive group such as a quinone diazide group, a naphthoquinone azide group, an aromatic azide group, or an aromatic cinnamoyl group has been introduced with several hydroxy groups of the foregoing resins. These alkali-soluble resins may be used alone or in combination of two or more thereof.

The alkali-soluble resin may be a urethane resin intramolecularly containing an acidic group such as carboxylic acid or sulfonic acid. This urethane resin may be used in combination with the above-described alkali-soluble resins.

The radiation-sensitive substance (photosensitive substance) (2) used for a resist composition according to the present invention is a substance that is mixed with the alkali-soluble resin and alters solubility of the alkali-soluble resin in a developer upon exposure to ultraviolet rays, far-ultraviolet rays, excimer laser beams, X-rays, electron beams, ion beams, molecular beams, γ-rays, or the like.

Examples of the radiation-sensitive substance include quinone diazide-based compounds, diazo-based compounds, diazide-based compounds, onium salt compounds, halogenated organic compounds, mixtures of halogenated organic compounds and organometallic compounds, organic acid ester compounds, organic acid amide compounds, organic acid imide compounds, and the poly(olefin sulfone) compounds described in Japanese Unexamined Patent Application Publication No. 59-152.

Examples of the quinone diazide-based compounds include 1,2-benzoquinone azide-4-sulfonate, 1,2-naphthoquinone diazide-4-sulfonate, 1,2-naphthoquinone diazide-5-sulfonate, 2,1-naphthoquinone diazide-4-sulfonate, 2,1-naphthoquinone diazide-5-sulfonate, and sulfonyl chlorides of quinone diazide derivatives such as 1,2-benzoquinone azide-4-sulfonyl chloride, 1,2-naphthoquinone diazide-4-sulfonyl chloride, 1,2-naphthoquinone diazide-5-sulfonyl chloride, 2,1-naphthoquinone diazide-4-sulfonyl chloride, and 2,1-naphthoquinone diazide-5-sulfonyl chloride.

Examples of the diazo compounds include condensation salt between p-diazodiphenylamine and formaldehyde or acetaldehyde; diazo resin inorganic salts that are reaction products between the above-described condensation product and hexafluorophosphate, tetrafluoroborate, perchlorate, periodate, or the like; and diazo resin organic salts that are reaction products between the above-described condensation product and a sulfonic acid and that are described in the specification of USP 3, 300, 309.

Examples of the azide compounds and diazide compounds include azide chalcone acid, diazide benzal methylcyclohexanones, and azide cinnamylideneacetophenones described in Japanese Unexamined Patent Application Publication No. 58-203438; and aromatic azide compounds and aromatic diazide compounds described in Journal of the Chemical Society of Japan No. 12, p1708-1714 (1983).

The halogenated organic compounds may be any halides of organic compounds. Specific examples include various compounds such as halogen-containing oxadiazole-based compounds, halogen-containing triazine-based compounds, halogen-containing acetophenone-based compounds, halogen-containing benzophenone-based compounds, halogen-containing sulfoxide-based compounds, halogen-containing sulfone-based compounds, halogen-containing thiazole-based compounds, halogen-containing oxazole-based compounds, halogen-containing trizole-based compounds, halogen-containing 2-pyrone-based compounds, halogen-containing aliphatic hydrocarbon-based compounds, halogen-containing aromatic hydrocarbon-based compounds, other halogen-containing heterocyclic compounds, and sulfenyl halide-based compounds; in addition, compounds that are used as halogen-based fire retardants such as tris(2,3-dibromopropyl) phosphate, tris(2,3-dibromo-3-chloropropyl) phosphate, chlorotetrabromomethane, hexachlorobenzene, hexabromobenzene, hexabromocyclododecane, hexabromobiphenyl, tribromophenyl allyl ether, tetrachlorobisphenol A, tetrabromobisphenol A, bis(bromoethylether) tetrabromobisphenol A, bis(chloroethylether) tetrachlorobisphenol A, tris(2,3-dibromopropyl) isocyanurate, 2,2-bis(4-hydroxy-3,5-dibromophenyl) propane, and 2,2-bis(4-hydroxyethoxy-3,5-dibromophenyl) propane; and compounds that are used as organochloro-based agricultural chemicals such as dichlorophenyltrichloroethane.

Examples of the organic acid esters include carboxylic acid esters and sulfonic acid esters. Examples of the organic acid amides include carboxylic acid amides and sulfonic acid amides. Examples of the organic acid imides include carboxylic acid imides and sulfonic acid imides. Such radiation-sensitive substances may be used alone or in combination of two or more thereof.

In a resist composition according to the present invention, the content of the radiation-sensitive substance is preferably 1 to 100 parts by mass, more preferably 3 to 50 parts by mass, with respect to 100 parts by mass of the alkali-soluble resin.

Examples of the solvent (3) used for a resist composition according to the present invention include solvents described in a book "Yozai pocket handbook" (edited by The Society of Synthetic Organic Chemistry, Japan; Ohmsha, Ltd.): for example, ketones such as acetone, methyl ethyl ketone, cyclohexanone, cyclopentanone, cycloheptanone, 2-heptanone, methyl isobutyl ketone, and butyrolactone; alcohols such as methanol, ethanol, n-propyl alcohol, isopropyl alcohol, n-butyl alcohol, isobutyl alcohol, tert-butyl alcohol, pentanol, heptanol, octanol, nonanol, and decanol; ethers such as ethylene glycol dimethyl ether, ethylene glycol diethyl ether, and dioxane; alcohol ethers such as ethylene glycol monomethyl ether, ethylene glycol monoethyl ether, ethylene glycol monopropyl ether, propylene glycol monomethyl ether, propylene glycol monoethyl ether, and propylene glycol monopropyl ether; esters such as ethyl formate, propyl formate, butyl formate, methyl acetate, ethyl acetate, butyl acetate, propyl acetate, methyl propionate, ethyl propionate, propyl propionate, butyl propionate, methyl butyrate, ethyl butyrate, butyl butyrate, propyl butyrate, ethyl lactate, and butyl lactate; monocarboxylic acid esters such as methyl 2-oxypropionate, ethyl 2-oxypropionate, propyl 2-oxypropionate, butyl 2-oxypropionate, methyl 2-methoxypropionate, ethyl 2-methoxypropionate, propyl 2-methoxypropionate, and butyl 2-methoxypropionate; cellosolve esters such as cellosolve acetate, methyl cellosolve acetate, ethyl cellosolve acetate, propyl cellosolve acetate, and butyl cellosolve acetate; propylene glycols such as propylene glycol, propylene glycol monomethyl ether, propylene glycol monomethyl ether acetate, propylene glycol monoethyl ether acetate, and propylene glycol monobutyl ether acetate; diethylene glycols such as diethylene glycol monomethyl ether, diethylene glycol monoethyl ether, diethylene glycol dimethyl ether, diethylene glycol diethyl ether, and diethylene glycol methyl ethyl ether; halogenated hydrocarbons such as trichloroethylene, chlorofluorocarbon solvents, HCFC, and HFC; perfluorinated solvents such as perfluorooctane; aromatic compounds such as toluene and xylene; and polar solvents such as dimethylacetamide, dimethylformamide, N-methylacetamide, and N-methylpyrrolidone. These solvents may be used alone or in combination of two or more thereof.

Examples of a coating process for a resist composition according to the present invention include spin coating, roll coating, dip coating, spray coating, blade coating, slit coating, curtain coating, and gravure coating. Prior to coating, the resist composition may be filtered through a filter to remove solid impurities.

As described above, a fluorine-based surfactant according to the present invention is advantageous as an additive for coating compositions (for example, paint compositions and photosensitive resin compositions). Application examples of a fluorine-based surfactant according to the present invention include hard coating materials, antiglare (AG) coating materials, and low-reflection coating materials for screens of various displays such as liquid crystal displays (hereafter abbreviated as "LCDs"), plasma displays (hereafter abbreviated as "PDPs") and organic EL displays (hereafter abbreviated as "OELDs"); color resists, inkjet inks, printing inks, and paints for forming RGB pixels of color filters (hereafter abbreviated as "CFs") of LCDs and the like; black resists, inkjet inks, printing inks, and paints for forming black matrices of CFs of LCDs and the like; paints for transparent protective films for protecting CF surfaces, used for CFs of LCDs and the like; resin compositions for pixel partition walls in OELDs; photoresists used for semiconductor fabrication; hard coating materials for optical recording media such as CDs, DVDs, and Blu-ray Discs; paints and hard coating materials for cellular phone casing; hard coating materials for screens of cellular phones; hard coating materials for transfer films for insert molding (IMD, IMF); paints and coating materials for various plastic molded articles such as household-electrical-appliance housing; printing inks and paints for various building materials such as decorative laminated sheets; coating materials for windowpanes of houses; woodwork paints for furniture and the like; coating materials for artificial/synthetic leather; paints and coating materials for FRP bathtubs; photosensitive materials for planographic plates (PS plates); inks for gravure printing and inkjet inks; and monolayer or multilayer coating compositions for other photofabrication processes and the like. By adding a fluorine-based surfactant according to the present invention to such coating compositions, high smoothness without pinholes, orange peel, unevenness in coating, crawling, or the like can be achieved.

In addition, by adding a fluorine-based surfactant according to the present invention to paints and coating materials containing fluorocarbon resins, the poly(perfluoroalkylene ether) chain enhances dispersibility of the fluorocarbon resins. Accordingly, the fluorine-based surfactant can provide not only the leveling property but also the function of a dispersing agent for fluorocarbon resins.

### EXAMPLES

Hereinafter, the present invention will be described further in detail with reference to Examples and Comparative examples. In Examples below, the weight-average molecular weight (Mw) and the number-average molecular weight (Mn) were determined by GPC measurement under the following conditions.

### [GPC measurement conditions]

Measurement apparatus: "HLC-8220 GPC" manufactured by Tosoh Corporation
Columns: guard column "HHR-H" (6.0 mm I.D. x4 cm) manufactured by Tosoh Corporation
+ "TSK-GEL GMHHR-N" (7.8 mm I.D. ×30 cm) manufactured by Tosoh Corporation
+ "TSK-GEL GMHHR-N" (7.8 mm I.D. x30 cm) manufactured by Tosoh Corporation
+ "TSK-GEL GMHHR-N" (7.8 mm I.D. ×30 cm) manufactured by Tosoh Corporation
+ "TSK-GEL GMHHR-N" (7.8 mm I.D. x30 cm) manufactured by Tosoh Corporation
Detector: ELSD ("ELSD2000" manufactured by Alltech associates, Inc.)
Data processing: "GPC-8020 Model II data analysis version 4.30" manufactured by Tosoh Corporation
Measurement conditions: Column temperature 40°C
   Developing solvent tetrahydrofuran (THF)
   Flow rate 1.0 ml/min
Sample: 1.0% by mass tetrahydrofuran solution (5 µl) in terms of resin solid content prepared by filtration through a microfilter
Standard sample: The following monodisperse polystyrenes having a known molecular weight were used in conformity with the measurement manual of the "GPC-8020 Model II data analysis version 4.30".

### (Monodisperse polystyrenes)

"A-500" manufactured by Tosoh Corporation
"A-1000" manufactured by Tosoh Corporation
"A-2500" manufactured by Tosoh Corporation
"A-5000" manufactured by Tosoh Corporation
"F-1" manufactured by Tosoh Corporation
"F-2" manufactured by Tosoh Corporation
"F-4" manufactured by Tosoh Corporation
"F-10" manufactured by Tosoh Corporation
"F-20" manufactured by Tosoh Corporation
"F-40" manufactured by Tosoh Corporation
"F-80" manufactured by Tosoh Corporation
"F-128" manufactured by Tosoh Corporation
"F-288" manufactured by Tosoh Corporation
"F-550" manufactured by Tosoh Corporation

### (Synthesis example 1)

A glass flask equipped with a stirrer, a thermometer, a condenser, and a dropping device was charged with 20 parts by mass of a perfluoropolyether compound having hydroxy groups at both ends and represented by a formula (a2-1-1) below, 20 parts by mass of diisopropyl ether serving as a solvent, 0.02 parts by mass of p-methoxyphenol serving as a polymerization inhibitor, and 3.1 parts by mass of triethylamine serving as a neutralizer. Stirring of the solution was initiated under air flow and, while the internal temperature of the flask was maintained at 10°C, 2.7 parts by mass of acrylic acid chloride was dropped over an hour. After the dropping was completed, the solution was stirred for an hour at 10°C, heated to 30°C and stirred for an hour, and heated to 50°C and stirred for 10 hours to cause a reaction. Gas chromatography measurement indicated disappearance of acrylic acid chloride. The solution was then mixed with 40 parts by mass of diisopropyl ether serving as a solvent. Subsequently, a washing process was repeated three times in which the solution was mixed with 80 parts by mass of ion-exchanged water, stirred, left to stand to separate an aqueous layer, and the aqueous layer was removed. To the solution, 0.02 parts by mass of p-methoxyphenol serving as a polymerization inhibitor was then added, 8 parts by mass of magnesium sulfate serving as a dehydrating agent was added. The solution was left to stand for a day to be completely dehydrated. The dehydrating agent was then removed by filtration.

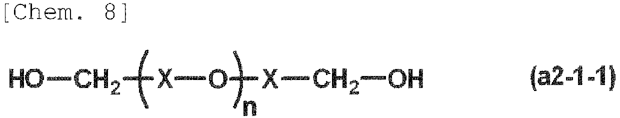

(In the formula, X's represent a perfluoromethylene group and a perfluoroethylene group; and a single molecule has, on average, seven perfluoromethylene groups, eight perfluoroethylene groups, and 46 fluorine atoms. The number-average molecular weight determined by GPC was 1,500.)

The solvent was then evaporated under a reduced pressure. Thus, a polymerizable monomer having a poly(perfluoroalkylene ether) chain and acryloyl groups at both ends of the chain and represented by a formula (A-1-1) below was obtained.

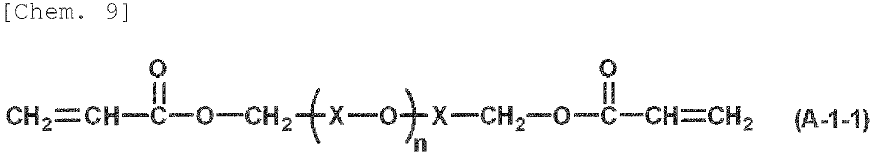

(In the formula, X's represent a perfluoromethylene group and a perfluoroethylene group; and a single molecule has, on average, seven perfluoromethylene groups, eight perfluoroethylene groups, and 46 fluorine atoms.)

### (Synthesis example 2)

A glass flask equipped with a stirrer, a thermometer, a condenser, and a dropping device was charged with 30 parts by mass of a block copolymer of ethylene oxide and propylene oxide represented by a formula (B1'-1) below, 2.8 parts by mass of acrylic acid, 64 parts by mass of toluene serving as a solvent, 0.03 parts by mass of phenothiazine serving as a polymerization inhibitor, and 0.6 parts by mass of methanesulfonic acid serving as a catalyst. Stirring of the solution was initiated under air flow and the solution was heated to 120°C and refluxed and dehydrated. After dehydration of 0.63 parts by mass was confirmed, the solution was cooled to 65°C and neutralized with triethylamine. After the neutralization, the solution was heated to 85°C and mixed with 2.3 parts by mass of ion-exchanged water to be separated into layers. The underlayer was extracted and the pH thereof was measured. Until the pH became 7 or more, the washing process was repeated. The solution was cooled to 30°C and then diluted with toluene to provide a 55 mass% toluene solution of a polymerizable monomer represented by the following formula (B1-1).

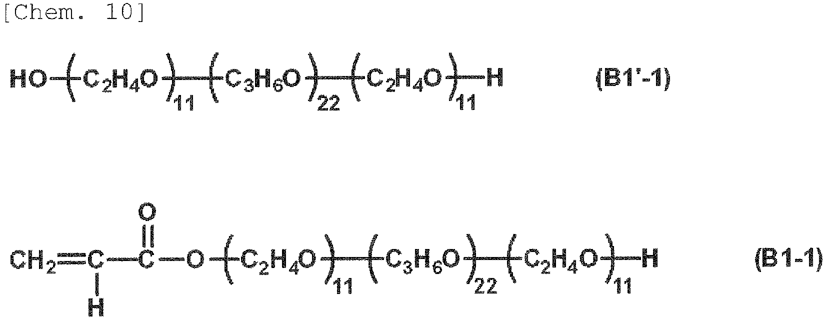

### (EXAMPLE 1)

A glass flask equipped with a stirrer, a thermometer, a condenser, and dropping devices was charged with 297.5 parts by mass of methyl isobutyl ketone serving as a solvent. This solvent was heated to 105°C while being stirred under nitrogen flow. Three solutions for dropping were then individually charged into the dropping devices: 59.5 parts by mass of the polymerizable monomer obtained in Synthesis example 1; a monomer solution in which 238 parts by mass of polypropylene glycol monomethacrylate ("BLEMMER PP-1000" manufactured by NOF CORPORATION, the number of the oxypropylene unit repeated: 6 on average) was dissolved in 154.4 parts by mass of methyl isobutyl ketone; and a polymerization initiator solution in which 44.6 parts by mass of t-butylperoxy-2-ethylhexanoate serving as a radical polymerization initiator was dissolved in 100.6 parts by mass of methyl isobutyl ketone. These solutions were simultaneously dropped over 2 hours while the internal temperature of the flask was maintained at 105°C. After the dropping was completed, the solution was stirred at 105°C for 10 hours and the solvent was then evaporated under a reduced pressure. Thus, a fluorine-based copolymer (1) serving as a fluorine-based surfactant was obtained. The molecular weights of the fluorine-based copolymer (1) were measured by GPC (molecular weights in terms of polystyrene) and the number-average molecular weight was found to be 2,500 and the weight-average molecular weight was found to be 6,000. The fluorine content of the starting material monomers used was 11% by mass.

### (EXAMPLE 2)

A glass flask equipped with a stirrer, a thermometer, a condenser, and dropping devices was charged with 112.4 parts by mass of methyl isobutyl ketone serving as a solvent. This solvent was heated to 105°C while being stirred under nitrogen flow. Three solutions for dropping were then individually charged into the dropping devices: 59.5 parts by mass of the polymerizable monomer obtained in Synthesis example 1; a monomer solution in which 238 parts by mass of polypropylene glycol monomethacrylate ("BLEMMER PP-1000" manufactured by NOF CORPORATION, the number of the oxypropylene unit repeated: 6 on average) was dissolved in 167.5 parts by mass of methyl isobutyl ketone; and a polymerization initiator solution in which 44.6 parts by mass of t-butylperoxy-2-ethylhexanoate serving as a radical polymerization initiator was dissolved in 83.7 parts by mass of methyl isobutyl ketone. These solutions were simultaneously dropped over 2 hours while the internal temperature of the flask was maintained at 105°C. After the dropping was completed, the solution was stirred at 105°C for 10 hours and the solvent was then evaporated under a reduced pressure. Thus, a fluorine-based copolymer (2) serving as a fluorine-based surfactant was obtained. The molecular weights of the fluorine-based copolymer (2) were measured by GPC (molecular weights in terms of polystyrene) and the number-average molecular weight was found to be 3,000 and the weight-average molecular weight was found to be 12,000. The fluorine content of the starting material monomers used was 11% by mass.

### (EXAMPLE 3)

A glass flask equipped with a stirrer, a thermometer, a condenser, and dropping devices was charged with 100.3 parts by mass of methyl isobutyl ketone serving as a solvent. This solvent was heated to 105°C while being stirred under nitrogen flow. Three solutions for dropping were then individually charged into the dropping devices: 20 parts by mass of the polymerizable monomer obtained in Synthesis example 1; a monomer solution in which 145.5 parts by mass of the polymerizable monomer solution obtained in Synthesis example 2 (80 parts by mass as the monomer) was mixed; and a polymerization initiator solution in which 15 parts by mass of t-butylperoxy-2-ethylhexanoate serving as a radical polymerization initiator was dissolved in 20 parts by mass of methyl isobutyl ketone. These solutions were simultaneously dropped over 2 hours while the internal temperature of the flask was maintained at 105°C. After the dropping was completed, the solution was stirred at 105°C for 10 hours and the solvent was then evaporated under a reduced pressure. Thus, a fluorine-based copolymer (3) serving as a fluorine-based surfactant was obtained. The molecular weights of the fluorine-based copolymer (3) were measured by GPC (molecular weights in terms of polystyrene) and the number-average molecular weight was found to be 5, 500 and the weight-average molecular weight was found to be 25, 000. The fluorine content of the starting material monomers used was 11% by mass.

### (EXAMPLE 4)

A glass flask equipped with a stirrer, a thermometer, a condenser, and dropping devices was charged with 143.4 parts by mass of methyl isobutyl ketone serving as a solvent. This solvent was heated to 105°C while being stirred under nitrogen flow. Three solutions for dropping were then individually charged into the dropping devices: 68.1 parts by mass of the polymerizable monomer obtained in Synthesis example 1; a monomer solution in which 57.9 parts by mass of polypropylene glycol monomethacrylate ("BLEMMER PP-1000" manufactured by NOF CORPORATION, the number of the oxypropylene unit repeated: 6 on average) was dissolved in 68.5 parts by mass of methyl isobutyl ketone; and a polymerization initiator solution in which 18.9 parts by mass of t-butylperoxy-2-ethylhexanoate serving as a radical polymerization initiator was dissolved in 21.9 parts by mass of methyl isobutyl ketone. These solutions were simultaneously dropped over 2 hours while the internal temperature of the flask was maintained at 105°C. After the dropping was completed, the solution was stirred at 105°C for 10 hours and the solvent was then evaporated under a reduced pressure. Thus, a fluorine-based copolymer (4) serving as a fluorine-based surfactant was obtained. The molecular weights of the fluorine-based copolymer (4) were measured by GPC (molecular weights in terms of polystyrene) and the number-average molecular weight was found to be 2,600 and the weight-average molecular weight was found to be 7,000. The fluorine content of the starting material monomers used was 30% by mass.

### (EXAMPLE 5)

A glass flask equipped with a stirrer, a thermometer, a condenser, and dropping devices was charged with 141.3 parts by mass of methyl isobutyl ketone serving as a solvent. This solvent was heated to 105°C while being stirred under nitrogen flow. Three solutions for dropping were then individually charged into the dropping devices: 68.5 parts by mass of the polymerizable monomer obtained in Synthesis example 1; a monomer solution in which 58.4 parts by mass of polyethylene glycol monomethacrylate ("BLEMMER PE-350" manufactured by NOF CORPORATION, the number of the oxyethylene unit repeated: 8 on average) was dissolved in 72.4 parts by mass of methyl isobutyl ketone; and a polymerization initiator solution in which 19 parts by mass of t-butylperoxy-2-ethylhexanoate serving as a radical polymerization initiator was dissolved in 22 parts by mass of methyl isobutyl ketone. These solutions were simultaneously dropped over 2 hours while the internal temperature of the flask was maintained at 105°C. After the dropping was completed, the solution was stirred at 105°C for 10 hours and the solvent was then evaporated under a reduced pressure. Thus, a fluorine-based copolymer (5) serving as a fluorine-based surfactant was obtained. The molecular weights of the fluorine-based copolymer (5) were measured by GPC (molecular weights in terms of polystyrene) and the number-average molecular weight was found to be 1,800 and the weight-average molecular weight was found to be 20,500. The fluorine content of the starting material monomers used was 30% by mass.

### (EXAMPLE 6)

A glass flask equipped with a stirrer, a thermometer, a condenser, and dropping devices was charged with 148.3 parts by mass of methyl isobutyl ketone serving as a solvent. This solvent was heated to 105°C while being stirred under nitrogen flow. Three solutions for dropping were then individually charged into the dropping devices: 70 parts by mass of the polymerizable monomer obtained in Synthesis example 1; a monomer solution in which 59.6 parts by mass of polyethylene glycol monomethacrylate ("BLEMMER PE-200" manufactured by NOF CORPORATION, the number of the oxyethylene unit repeated: 4.5 on average) was dissolved in 71 parts by mass of methyl isobutyl ketone; and a polymerization initiator solution in which 19.4 parts by mass of t-butylperoxy-2-ethylhexanoate serving as a radical polymerization initiator was dissolved in 21.3 parts by mass of methyl isobutyl ketone. These solutions were simultaneously dropped over 2 hours while the internal temperature of the flask was maintained at 105°C. After the dropping was completed, the solution was stirred at 105°C for 10 hours and the solvent was then evaporated under a reduced pressure. Thus, a fluorine-based copolymer (6) serving as a fluorine-based surfactant was obtained. The molecular weights of the fluorine-based copolymer (6) were measured by GPC (molecular weights in terms of polystyrene) and the number-average molecular weight was found to be 1, 800 and the weight-average molecular weight was found to be 11,500. The fluorine content of the starting material monomers used was 30% by mass.

### (EXAMPLE 7)

A glass flask equipped with a stirrer, a thermometer, a condenser, and dropping devices was charged with 152.7 parts by mass of methyl isobutyl ketone serving as a solvent. This solvent was heated to 105°C while being stirred under nitrogen flow. Three solutions for dropping were then individually charged into the dropping devices: 70 parts by mass of the polymerizable monomer obtained in Synthesis example 1; a monomer solution in which 59.6 parts by mass of polypropylene glycol monomethacrylate ("BLEMMER PP-800" manufactured by NOF CORPORATION, the number of the oxypropylene unit repeated: 13 on average) was dissolved in 66.5 parts by mass of methyl isobutyl ketone; and a polymerization initiator solution in which 19.4 parts by mass of t-butylperoxy-2-ethylhexanoate serving as a radical polymerization initiator was dissolved in 21.5 parts by mass of methyl isobutyl ketone. These solutions were simultaneously dropped over 2 hours while the internal temperature of the flask was maintained at 105°C. After the dropping was completed, the solution was stirred at 105°C for 1.0 hours and the solvent was then evaporated under a reduced pressure. Thus, a fluorine-based copolymer (7) serving as a fluorine-based surfactant was obtained. The molecular weights of the fluorine-based copolymer (7) were measured by GPC (molecular weights in terms of polystyrene) and the number-average molecular weight was found to be 2,200 and the weight-average molecular weight was found to be 4,200. The fluorine content of the starting material monomers used was 30% by mass.

### (EXAMPLE 8)

A glass flask equipped with a stirrer, a thermometer, a condenser, and dropping devices was charged with 146.6 parts by mass of methyl isobutyl ketone serving as a solvent. This solvent was heated to 105°C while being stirred under nitrogen flow. Three solutions for dropping were then individually charged into the dropping devices: 69.9 parts by mass of the polymerizable monomer obtained in Synthesis example 1; a monomer solution in which 45.9 parts by mass of methoxy polyethylene glycol methacrylate ("NK ester M-230G" manufactured by Shin Nakamura Chemical Co., Ltd., the number of the oxypropylene unit repeated: 23 on average) and 13.7 parts by mass of dicyclopentanyl acrylate ("FANCRYL FA-513A" manufactured by Hitachi Chemical Company, Ltd.) were dissolved in 72.2 parts by mass of methyl isobutyl ketone; and a polymerization initiator solution in which 19.4 parts by mass of t-butylperoxy-2-ethylhexanoate serving as a radical polymerization initiator was dissolved in 21.6 parts by mass of methyl isobutyl ketone. These solutions were simultaneously dropped over 2 hours while the internal temperature of the flask was maintained at 105°C. After the dropping was completed, the solution was stirred at 105°C for 10 hours and the solvent was then evaporated under a reduced pressure. Thus, a fluorine-based copolymer (8) serving as a fluorine-based surfactant was obtained. The molecular weights of the fluorine-based copolymer (8) were measured by GPC (molecular weights in terms of polystyrene) and the number-average molecular weight was found to be 3,300 and the weight-average molecular weight was found to be 8,800. The fluorine content of the starting material monomers used was 30% by mass.

### (COMPARATIVE EXAMPLE 1)

A glass flask equipped with a stirrer, a thermometer, a condenser, and dropping devices was charged with 134 parts by mass of methyl isobutyl ketone serving as a solvent. This solvent was heated to 110°C while being stirred under nitrogen flow. Two solutions for dropping were then individually charged into the dropping devices: a monomer solution in which 30.2 parts by mass of perfluorooctylethyl acrylate (hereafter abbreviated as "PFOEA") and 70.4 parts by mass of polypropylene glycol monomethacrylate ("BLEMMER PP-1000" manufactured by NOF CORPORATION, the number of the oxypropylene unit repeated: 6 on average) were dissolved in 50.3 parts by mass of methyl isobutyl ketone; and a polymerization initiator solution in which 7.5 parts by mass of t-butylperoxy-2-ethylhexanoate serving as a radical polymerization initiator was dissolved in 50.3 parts by mass of methyl isobutyl ketone. These solutions were simultaneously dropped over 2 hours while the internal temperature of the flask was maintained at 110°C. After the dropping was completed, the solution was stirred at 110°C for 10 hours. Thus, a fluorine-based copolymer (9) was obtained. The molecular weights of the fluorine-based copolymer (9) were measured by GPC (molecular weights in terms of polystyrene) and the number-average molecular weight was found to be 2,400 and the weight-average molecular weight was found to be 4,000. The fluorine content of the starting material monomers used was 19% by mass.

### (COMPARATIVE EXAMPLE 2)

A glass flask equipped with a stirrer, a thermometer, a condenser, and dropping devices was charged with 126.3 parts by mass of methyl isobutyl ketone serving as a solvent. This solvent was heated to 110°C while being stirred under nitrogen flow. Two solutions for dropping were then individually charged into the dropping devices: a monomer solution in which 50.5 parts by mass of PFOEA and 50.5 parts by mass of polypropylene glycol monomethacrylate ("BLEMMER PP-1000" manufactured by NOF CORPORATION, the number of the oxypropylene unit repeated: 6 on average) were dissolved in 12.6 parts by mass of methyl isobutyl ketone; and a polymerization initiator solution in which 5.1 parts by mass of t-butylperoxy-2-ethylhexanoate serving as a radical polymerization initiator was dissolved in 12.6 parts by mass of methyl isobutyl ketone. These solutions were simultaneously dropped over 2 hours while the internal temperature of the flask was maintained at 110°C. After the dropping was completed, the solution was stirred at 110°C for 10 hours. Thus, a fluorine-based copolymer (10) was obtained. The molecular weights of the fluorine-based copolymer (10) were measured by GPC (molecular weights in terms of polystyrene) and the number-average molecular weight was found to be 3,500 and the weight-average molecular weight was found to be 6,500. The fluorine content of the starting material monomers used was 31% by mass.

Table 1 summarizes the fluorine-based copolymers (1) to (10) obtained in EXAMPLES 1 to 8 and COMPARATIVE EXAMPLES 1 and 2 above in terms of the type of the polymerizable monomer that is a starting material, the fluorine content in the starting materials, the number-average molecular weight (Mn), the weight-average molecular weight (Mw), and bioaccumulation safety. Note that evaluation in terms of bioaccumulation safety was performed on the basis of an evaluation system described below.

### [Evaluation of bioaccumulation safety]

Each fluorine-based surfactant was evaluated in terms of bioaccumulation safety on the basis of the following evaluation system.
Y: not containing perfluoroalkyl group having 8 or more carbon atoms, hence low probability of bioaccumulation and high safety
N: containing perfluoroalkyl group having 8 or more carbon atoms, hence high probability of bioaccumulation and low safety

**[Table 1]**

| | Example 1 | Example 2 | Example 3 | Example 4 | Example 5 | Example 6 | Example 7 | Example 8 | Comparative example 1 | Comparative example 2 |
|---|---|---|---|---|---|---|---|---|---|---|
| Type of fluorine-based copolymer (fluorine-based surfactant) | (1) | (2) | (3) | (4) | (5) | (6) | (7) | (8) | (9) | (10) |
| Type of fluorine-based polymerizable monomer | PFPE | PFPE | PFPE | PFPE | PFPE | PFPE | PFPE | PFPE | PFOEA | PFOEA |
| Type of polymerizable monomer having oxyalkylene group | PO (n = 6) | PO (n=6) | EO/PO/EO (n = 11/22/11) | PO (n = 6) | EO (n = 8) | EO (n = 4.5) | PO (n = 13) | PO (n = 23) | PO (n = 6) | PO (n = 6) |
| Fluorine content in starting materials of fluorine-based copolymer (mass%) | 11 | 11 | 11 | 30 | 30 | 30 | 30 | 30 | 19 | 31 |
| Number-average molecular weight (Mn) | 2,500 | 3,000 | 5,500 | 2,600 | 1,800 | 1,800 | 2,200 | 3,300 | 2,400 | 3,500 |
| Weight-average molecular weight (Mw) | 6,000 | 12,000 | 25,000 | 7,000 | 20,500 | 11,500 | 4,200 | 8,800 | 4,000 | 6,500 |
| Bioaccumulation safety | Y | Y | Y | Y | Y | Y | Y | Y | N | N |

In Table 1, "PFPE" denotes the polymerizable monomer obtained in Synthesis example 1 that has a (perfluoroalkylene ether) chain and acryloyl groups at both ends of the chain. As to the type of the polymerizable monomer having an oxyalkylene group, the oxyalkylene group only is described: "PO" represents an oxypropylene group; "EO" represents an oxyethylene group; the number in parentheses represents the number of such a group repeated (on average).

### (EXAMPLES 4 to 6 and COMPARATIVE EXAMPLES 3 to 5)

The fluorine-based copolymers (1) to (10) obtained in EXAMPLES 1 to 8 and COMPARATIVE EXAMPLES 1 and 2 above were used as fluorine-based surfactants and the following measurement and evaluation were performed.

### [Measurement of static surface tension]

A solution was prepared such that the solid content of a fluorine-based surfactant became 0.1% by mass with respect to propylene glycol monomethyl ether acetate (hereafter abbreviated as "PGMEA"), which is a solvent generally used for resist compositions. The solution was measured with a self-balancing electro surface tensiometer ("ESB-IV type", manufactured by Kyowa Kagaku K. K.) in terms of static surface tension by the Wilhelmy method employing a platinum plate at 23°C. Note that the static surface tension of PGMEA alone was 27.6 mN/m² (reference example).

### [Preparation of base composition of paint compositions for evaluation]

A base composition of paint compositions for evaluation was prepared by uniformly mixing, as ultraviolet-curable paint compositions, 50 parts by mass of pentafunctional non-yellowing urethane acrylate, 50 parts by mass of dipentaerythritol hexaacrylate, and 25 parts by mass of butyl acetate; 5 parts by mass of a photopolymerization initiator ("IRGACURE 184" manufactured by BASF Japan Ltd.; 1-hydroxycyclohexyl phenyl ketone); and, as solvents, 54 parts by mass of toluene, 28 parts by mass of 2-propanol, 28 parts by mass of ethyl acetate, and 28 parts by mass propylene glycol monomethyl ether.

### [Preparation of paint compositions for evaluation]

To 268 parts by mass of the base composition prepared above, 1 part by mass of one of five fluorine-based surfactants that were the fluorine-based copolymers (1) to (5) obtained in EXAMPLES 1 to 3 and COMPARATIVE EXAMPLES 1 and 2 was individually added, uniformly mixed, and subsequently subjected to microfiltration through a 0.1 µm polytetrafluoroethylene (PTFE) filter. Thus, paint compositions for evaluation were obtained. In addition, a composition composed of the base composition alone and not containing other components was also prepared and defined as COMPARATIVE EXAMPLE 5.

### [Evaluation of coatability]

Each of the paint compositions for evaluation prepared above was applied to a 10 cm × 10 cm chromium-plated glass substrate by spin-coating at 500 rpm and subsequently dried by heating at 60°C for 5 minutes. Thus, a glass substrate having a coating film was provided. The surface of the obtained coating film was visually inspected for the presence or absence of irregularities (coating unevenness) of the coating film with a sodium lamp and evaluated in terms of coatability in accordance with the following evaluation system.

### (Coatability: coating unevenness)

AA: no observation of coating unevenness
A: observation of slight coating unevenness (the area of coating unevenness was less than 10% of the total area)
B: observation of some coating unevenness (the area of coating unevenness was 10% or more and less than 30% of the total area)
C: observation of considerable coating unevenness (the area of coating unevenness was 30% or more of the total area)

The results of the measurement and evaluation are described in Table 2.

**[Table 2]**

| | Example 4 | Example 5 | Example 6 | Example 7 | Example 8 | Example 9 | Example 10 | Example 11 | Comparative example 3 | Comparative example 4 | Comparative example 5 | Reference example |
|---|---|---|---|---|---|---|---|---|---|---|---|---|
| Type of fluorine-based copolymer (fluorine-based surfactant) | (1) | (2) | (3) | (4) | (5) | (6) | (7) | (8) | (9) | (10) | None | - |
| Static surface tension (mN/m²) (0.1mass% PGMEA solution) | 22.2 | 22.8 | 20.5 | 19.7 | 19.2 | 19.3 | 18.8 | 19.3 | 26.4 | 21.8 | - | 27.6 |
| Decrease in static surface tension (mN/m²) (0.1 mass% PGMEA solution) | 5.4 | 4.8 | 7.1 | 7.9 | 8.4 | 8.3 | 8.8 | 8.3 | 1.2 | 5.8 | - | |
| Coating unevenness | AA | AA | AA | AA | A | A | AA | A | A | B | C | - |

The results of EXAMPLES 4 to 11 in Table 2 indicate that the solutions prepared by adding the fluorine-based surfactants of EXAMPLES 1 to 8 according to the present invention at a concentration of 0.1% by mass to PGMEA serving as a solvent had a static surface tension of 18.8 to 22.8 mN/m², which is much smaller than the static surface tension of PGMEA alone, 27.6 mN/m², and the leveling property was enhanced. In addition, it has been demonstrated that resist compositions containing fluorine-based surfactants of EXAMPLES 1 to 3 according to the present invention have good coatability and occurrence of coating unevenness can be suppressed.

In contrast, the fluorine-based surfactant of COMPARATIVE EXAMPLE 1 employs, as a starting material, a monomer having a perfluoroalkyl group having 8 carbon atoms. Since the fluorine-based surfactant has the perfluoroalkyl group having 8 carbon atoms, it has a high probability of bioaccumulation and a problem of low safety. In addition, although the fluorine-based surfactant has a fluorine content of 19% by mass, which is higher than the fluorine content (11% by mass) of the fluorine-based copolymers (1) to (3) (EXAMPLES 4 to 6) according to the present invention, the decrease in the static surface tension is small.

The fluorine-based surfactant of COMPARATIVE EXAMPLE 2 employs, as a starting material, a monomer having a perfluoroalkyl group having 8 carbon atoms and has a fluorine content of 31% by mass. Since the fluorine-based surfactant has the perfluoroalkyl group having 8 carbon atoms, it has a high probability of bioaccumulation and a problem of low safety. In addition, although the fluorine-based surfactant has a fluorine content similar to those of the fluorine-based copolymers (4) to (8) (EXAMPLES 7 to 11) according to the present invention, it has a problem that the decrease in the static surface tension is relatively small and coating unevenness is caused.

Regarding COMPARATIVE EXAMPLE 3 in which no fluorine-based surfactant was used, the composition has a poor leveling property and causes serious coating unevenness.

## Claims

1. A fluorine-based surfactant comprising a copolymer synthesized by copolymerizing, as essential monomers, a polymerizable monomer (A) having a poly(perfluoroalkylene ether) chain and polymerizable unsaturated groups at both ends of the chain and a polymerizable monomer (B) having an oxyalkylene group and a polymerizable unsaturated group.

2. The fluorine-based surfactant according to Claim 1, wherein the polymerizable monomer (B) includes a polymerizable monomer represented by a general formula (B1) below 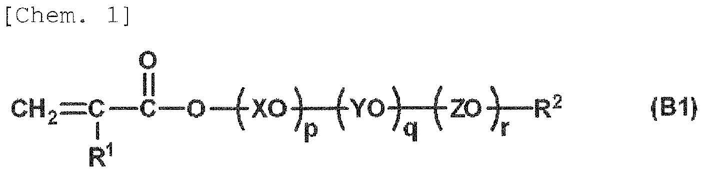 (in the formula, R¹ represents a hydrogen atom or a methyl group; X, Y, and Z each independently represent an alkylene group; p, q, and r each represent an integer of 0 or 1 or more; a total of p, q, and r is an integer of 1 or more; and R² represents a hydrogen atom or an alkyl group having 1 to 6 carbon atoms.)

3. A coating composition comprising the fluorine-based surfactant according to Claim 1 or 2.

4. A resist composition comprising the fluorine-based surfactant according to Claim 1 or 2.
